# EUROPEAN PATENT SPECIFICATION

(11) **EP 2 024 990 B1**
(45) Date of publication and mention of the grant of the patent: **29.06.2011**
(21) Application number: 07735905.7
(22) Date of filing: 15.05.2007
(51) Int. Cl.: H01L 21/02, H01L 27/08, H01L 23/522, H01L 21/265, H01L 21/266

(54) **METHOD OF INCREASING THE QUALITY FACTOR OF AN INDUCTOR IN A SEMICONDUCTOR DEVICE**
VERFAHREN ZUR VERGRÖSSERUNG DES GÜTEFAKTORS EINER INDUKTIVITÄT IN EINER HALBLEITERANORDNUNG
PROCÉDÉ D'AUGMENTATION DU FACTEUR DE QUALITÉ D'UN INDUCTEUR DANS UN DISPOSITIF À SEMI-CONDUCTEUR

(30) Priority: 18.05.2006 EP 06300487
(43) Date of publication of application: 18.02.2009
(73) Proprietor: IPDIA, 14000 Caen (FR)
(72) Inventor: JACQUELINE, Sebastien, NL-5656 AG Eindhoven (NL)
(74) Representative: Vignesoult, Serge L. M.
(86) International application number: PCT/IB2007/051835
(87) International publication number: WO 2007/135620

(56) References cited:
- EP-A- 1 592 047
- US-A- 6 046 109
- US-A- 6 093 936
- US-B1- 6 258 688
- US-B1- 6 475 887
- US-B1- 6 534 406

## Description

This invention relates generally to a method of improving the quality factor of an inductor in a semiconductor device by reducing substrate losses.

Radio frequency (RF) circuits have not easily been integrated into silicon chips using a single semiconductor process technology the way of system-on-chip industry is doing with digital circuits. Demanding RF applications will require system-in-package solutions that utilize multiple semiconductor technologies to achieve the necessary performance. New process technologies and integration techniques are being developed that will allow these system-in-package RF solutions to be produced at an acceptable cost, even for high-volume consumer product applications.

Current silicon process technologies allow the fabrication of integrated transistors with gain characteristics that extend well beyond 40GH_{z}, meeting all the requirements of existing wireless applications in the consumer electronics domain. RF performance, however, relies as much on the passive devices that surround these transistors as on the transistors themselves. Because of their construction, passive devices such as capacitors and inductors have traditionally been implemented as discrete components and have failed to keep pace with the levels of miniaturization offered by semiconductor technologies, and methods are curently being developed for integrating passive components onto silicon in a way that not only enhances RF performance, but also meets low-cost, high-volume production requirements.

Integrating passive components onto silicon does not necessarily mean integration on the same piece of silicon (or "die") as the active transitors. What it does mean, however, is that passive component technologies need to leverage the integration capabilities inherent in silicon chip production. Passive and active dies can then be combined into packages.

Several techniques are applied to integrate passive components. Inductors and capacitors, for example, are fabricated within the metallization layers deposited onto the silicon.

More specifically, an inductor may be realised by forming a planar metal spiral on the semiconductor wafer. In recent years, as semiconductor devices have become increasingly highly integrated, highly conductive copper has been widely used for this purpose in order to maximise the quality factor of the inductor. Nevertheless, the Q-factor of such inductors tends to be relatively poor, mainly due to the high substrate RF loss of the low resistivity Si wafers and the ohmic loss of the spiral metal. Since the ohmic loss can be further reduced by using thick copper lines, the substrate loss becomes the dominant determining factor factor of an inductor's Q-factor and, even when high resistivity silicon is used to suppress substrate-induced losses, such as eddy currents, the Q factor is still inadequate for many high frequency applications. This is due to an accumulated charge at the interface between the silicon substrate and the dielectric (SiO₂) layer which is grown on the silicon substrate by means of thermal oxidation so as to separate the metallization layer from the high resistance Silicon substrate.

Several methods have been proposed to overcome this problem, whereby the influence of the above-mentioned accumulated charge is reduced and the effective resistance of the substrate increased by the creation of an amorphous layer on the substrate below the inductor.

It is known to create such an amorphous layer on top of the substrate by performing an implantation process to implant into the substrate, heavy ions (typically Argon in the case of a Silicon substrate, although N Is also considered to be suitable) and several ways are known to integrate the Argon implantation step into the device process flow in the typical case where the device includes a polysilicon layer. In a first known method, the polysilicon processing stage is completed, i.e. the polysilicon layer is etched, the resist layer is stripped and the remaining polysilicon areas are annealed, followed by Argon implantation. However, if the polysilicon remains unmasked during Argon implantation, the surface of the polysilicon can become damaged, whereas the incorporation of an additional masking step increases costs. In an alternative method, the Argon is implanted, unmasked, before the polysilicon processing stage, after the growth of the dielectric layer (SiO₂) on the high resistance silicon substrate. However, the thermal budget of the polysilicon deposition and subsequent processing will cause the amorphous layer created by the implantation step to be partially crystallised.

K.T. Chan et al propose, in Large Q-Factor Improvement for Spiral Inductors on Silicon Using Proton Imp/antation, IEEE Microwave and Wireless Components Letters, Vol. 13, No. 11, November 2003, to perform a proton implant after full wafer fabrication so as to introduce impurities into a layer of Silicon below the inductor, thereby increasing its resistance and improving its Q-factor. Although the performance of the proton implant after completion of the full wafer fabrication process avoids contamination to the VLSI process line, it also necessitates additional process steps at the end of the fabrication process, which has a significant cost implication.

US 6 475 887 B1 (D1) discloses a method of manufacturing a semiconductor device preventing impurity diffusion in heat treatment.

US 6 046 109 A (D2) discloses a process form forming a semi-insulating region within a single crystal semiconductor body, comprising irradiating said region with high energy electromagnetic radiation.

It is therefore preferred to provide a method of manufacturing a semiconductor device including an inductor, whereby an amorphous layer is formed on the semiconductor substrate at the front-end of the fabrication process of the device without the need for an additional masking step, as recited in claim 1.

In accordance with the present invention, there is provided is method of fabricating an integrated circuit carrying at least one passive component, the method comprising providing a semiconductor substrate on which may be formed a passive component, depositing a layer of conductive material on said substrate, providing on said layer of a patterned resist layer and etching said layer, performing an ion implantation step so as to create an amorphous layer on said substrate in the areas thereof not covered by said etched polysilicon layer and, after said ion implantation step, removing said resist layer.

Thus, by performing the ion implantation step after the polysilicon layer has been deposited and etched but before the resist layer is stripped and the polysilicon annealed, an amorphous layer can be created on the substrate without an additional masking step and without adversely impacting the polysilicon layer.

The ion implantation step is preferably performed using heavy ions, such as Nitrogen or, more preferably Argon. The passive component may comprise a multi-turn inductor, comprising a metal spiral formed on the substrate. The integrated circuit preferably carries at least one additional passive component, such as a planar capacitor, a pit capacitor or a resistor. The at least one passive component is preferably isolated from the semiconductor substrate by a dielectric layer which is preferably silicon dioxide in the case where the substrate is a silicon substrate.

The present invention also extends to an integrated circuit carrying at least one passive component fabricated by means of the above method.

These and other aspects of the present invention will be apparent from, and elucidated with reference to, the embodiments described herein.

Embodiments of the present invention will now be described by way of examples only and with reference to the accompanying drawings, in which:
Figure 1 is a schematic cross-sectional view of a die fabricated by means of the PASSI process;
Figure 2 is a schematic diagram illustrating the principal components of a pit capacitor;
Figure 3 is a schematic cross-sectional view of an integrated circuit carrying RF passive components; and
Figures 4a to 4e are schematic diagrams illustrating the principal steps of a fabrication process according to an exemplary embodiment of the present invention.

In recent years, a silicon process has been developed for use on an industrial scale for the fabrication of high-Q passives, like inductors and capacitors, for front-end applications between 0.9 and 2GHz. This process, uses high-resistive silicon (HRS) as a carrier substrate, and will be used herein to describe an exemplary embodiment of the present invention. However, it will be appreciated by a person skilled in the art that the present invention may also be applied to other passive integration techniques.

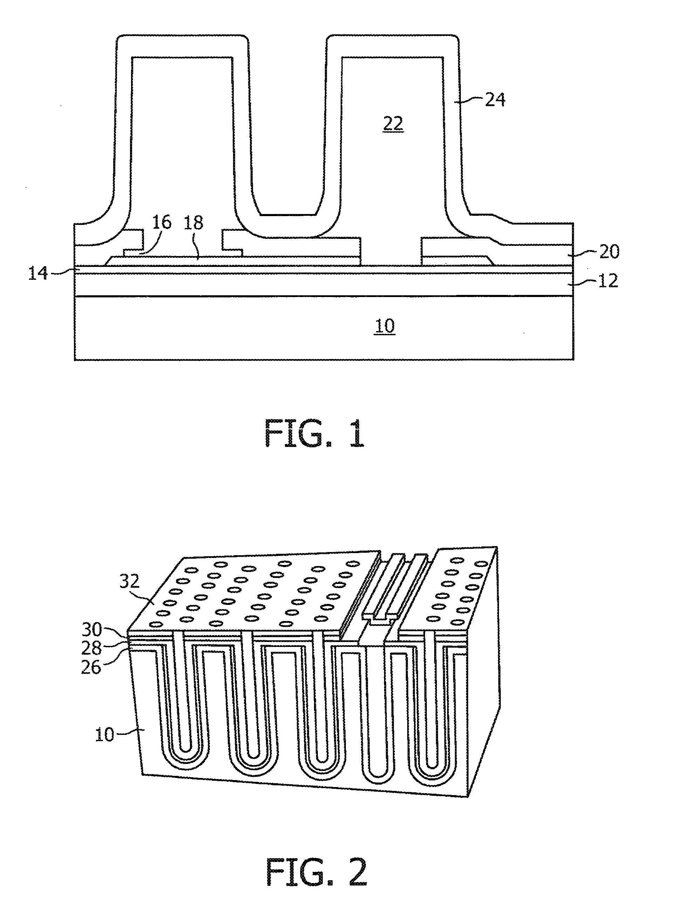

Referring to Figure 1 of the drawings, high ohmic silicon wafers with a specific resistivity of p > 4kΩ are used as a carrier 10 for the fabrication of inductor-capacitor networks. High ohmic Si is used in order to limit the dissipation of RF power that is coupled to the substrate. The Si substrate 10 is isolated by a layer 12 of thermally grown oxide. Two relatively thin sputtered A1 layers 14, 16 separated by a PECVD SiNₓ dielectric 18 are used for defining the capacitors. The process continues with the deposition of a PECVD SiOₓ decoupling layer 20 which electrically decouples the capacitor from the Al top metallization 22 which is deposited next. The 5µm thick Al top metallization 22 is used for defining high-Q inductors. The process ends with the deposition of a PECVD SiNₓ scratch protection layer 24. This process is currently bring used to produce naked die, containing circuits such as impedance matching networks or resonant filters, that can be assembled into hybrid-circuit RF modules.

Another process is currently being devloped, in which a single low-cost silicon die not only carries all the required passive components, but also the interconnect pattern between them. As part of the development process, ways of increasing the capacitance density are being investigated. The metal-insulator-metal (MIM) capacitors fabricated in the process described above achieve capacitance densities up to 150 pF/mm² but this still limits the capacitance value that can be achieved in a realistic area of silicon.

One approach being investigated to increase capacitance density is to increase the surface area of the capacitor's electrodes without unduly increasing the area of silicon occupied. Referring to Figure 2 of the drawings, the device being developed, called a 'pit capacitor', is fabricated by etching a matrix of deep holes into the surface of the n⁻ silicon substrate 10, followed by an n+ diffusion to create the lower electrode 26, and dielectric, polysilicon 30 and metal depositions to create the dielectric layer 28 and the upper electrode 32. Capacitance densities of up to 100 nF/mm² have been demonstrated using this approach.

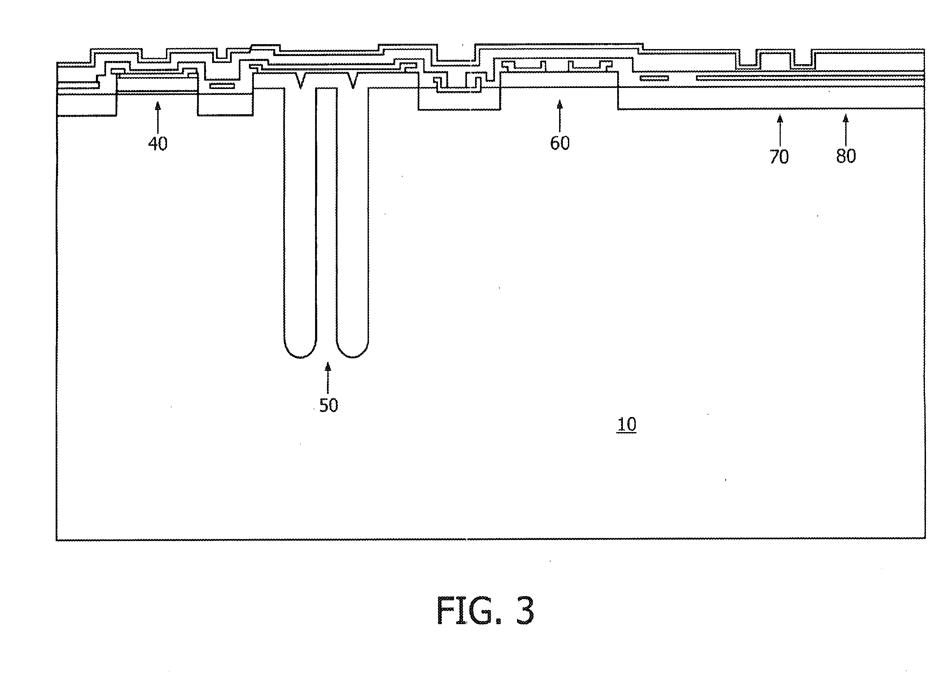

Referring to Figure 3 of the drawings, therefore, the above-described process can be used to fabricate a single silicon die 10 carrying passive components such as a planar capacitor 40, a pit capacitor 50, a resistor 60, a multi-turn inductor (represented by site 70) and a bumping pad 80, and the interconnect pattern between them.

As explained above, in order to improve the quality factor of the (eventual) inductor 70, it is proposed to perform an implant of heavy ions, preferably but not necessarily Argon, to create an amorphous layer on top of the substrate. Suitable ions, other than Argon, include Nitrogen, Silicon (Si), Oxygen (O), Carbon (C), Neon (Ne). A person skilled in the art will envisage that also other heavy ions may be implanted.

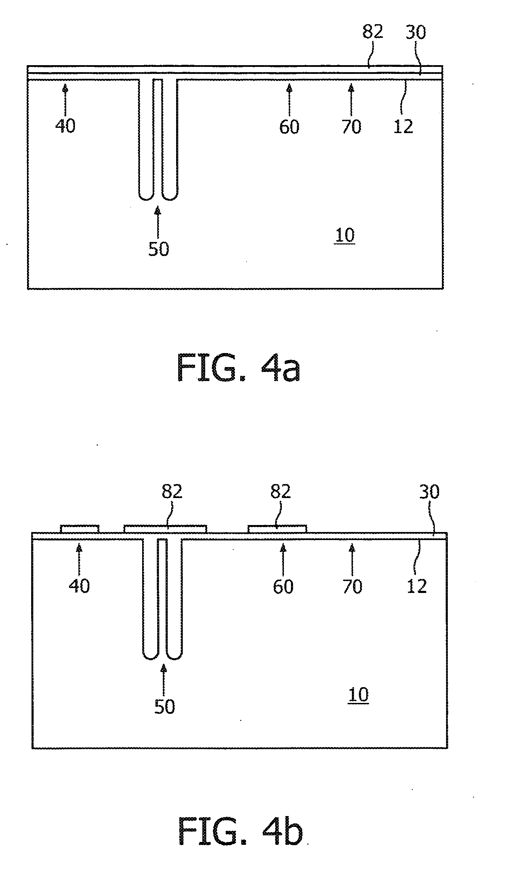

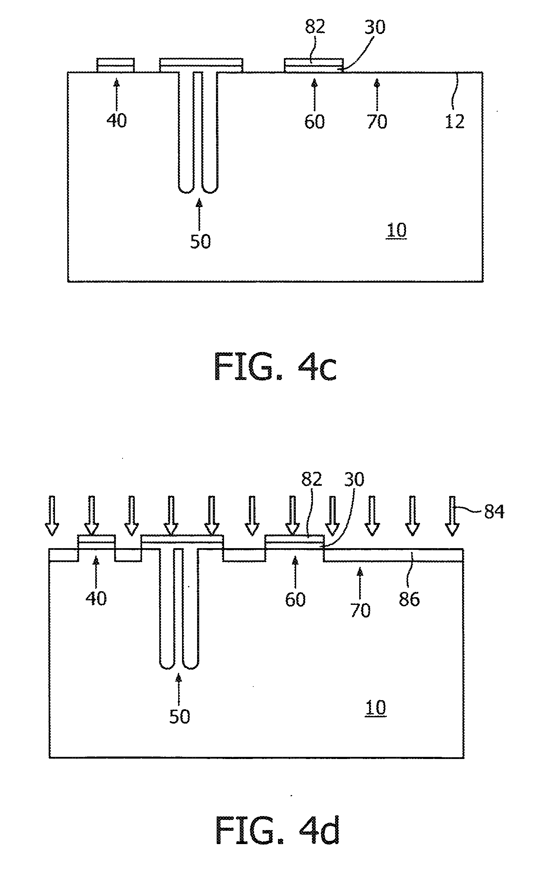

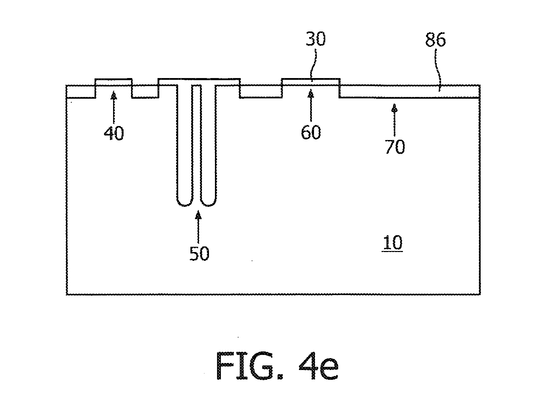

Referring to Figures 4a to 4e of the drawings, in a process according to an exemplary embodiment of the present invention, once the planar capacitor 40, the pit capacitor 50 and the resistor 60 have been fabricated in the silicon substrate 10, a photoresist coating 82 is applied over the polysilicon layer 30 (Figure 4a) and developed (Figure 4b) to create a mask for the polysilicon etching process (Figure 4c). Note that reference numeral 70 denotes the site of a multi-turn inducer but the multi-turn inducer itself is fabricated later on in the process (with the back-end metals). After etching of the polysilicon layer 30, an Argon implantation process 84 is performed to create an amorphous layer 86 on top of the substrate 10 (Figure 4d). The Argon implant is performed by an ion implanter. This machine ionizes the species to be implanted and scans the wafer with three main parameters: the dose (around 10¹⁶ ions/cm²), the energy (around 50 KeV) and the tilt of the incident beam (7 degrees). The impacts create crystalline damage at the surface of the wafer. In this way, an amorphous layer can be created. After the implantation process, the resist layer is stripped from the remaining polysilicon 30 and the remaining polysilicon 30 is annealed (Figure 4e).

Thus, the Argon implant is realised and the amorphous layer created below the inductor 70 without extra masking steps and without degradation of the polysilicon layer. The Argon implant is performed immediately after the polysilicon etching step so that the polysilicon is still protected by the photoresist layer. The polysilicon annealing step is then performed once the resist layer has been stripped.

It should be noted that the above-mentioned embodiments illustrate rather than limit the invention, and that those skilled in the art will be capable of designing many alternative embodiments without departing from the scope of the invention as defined by the appended claims. In the claims, any reference signs placed in parentheses shall not be construed as limiting the claims. The word "comprising" and "comprises", and the like, does not exclude the presence of elements or steps other than those listed in any claim or the specification as a whole. The singular reference of an element does not exclude the plural reference of such elements and vice-versa. The invention may be implemented by means of hardware comprising several distinct elements, and by means of a suitably programmed computer. In a device claim enumerating several means, several of these means may be embodied by one and the same item of hardware. The mere fact that certain measures are recited in mutually different dependent claims does not indicate that a combination of these measures cannot be used to advantage.

## Claims

1. A method of fabricating an integrated circuit carrying at least one passive component (70), the method comprising providing a semiconductor substrate (10) on which may be formed a passive component, depositing a layer of **conductive material (30)** on said substrate (10), providing on said layer of **conductive material (30)** a patterned resist layer (82) **as a mask** and etching said layer **of conductive material (30) characterized in that the method further comprises** performing an ion implantation step (84) so as to create an amorphous layer (86) on said substrate in the areas thereof not covered by said etched layer of **conductive material (30) and said patterned resist layer (82)** and, after said ion implantation step, removing said **patterned** resist layer (82).»

2. A method according to claim 1, wherein the ion implantation step is performed using heavy ions.

3. A method according to claim 2, wherein said heavy ions comprise Argon.

4. A method according to claim 1, wherein said passive component comprises a multi-turn inductor (70), comprising a metal spiral formed on the substrate (10).

5. A method according to claim 1, wherein said integrated circuit carries at least one additional passive component.

6. A method according to claim 5, wherein said at least one additional passive component comprises a planar capacitor (40), a pit capacitor (50) or a resistor (60).

7. A method according to claim 1, wherein said at least one passive component is isolated from the semiconductor substrate by a dielectric layer.

8. A method according to claim 7, wherein said dielectric layer comprises silicon dioxide and said substrate comprises a silicon substrate.

9. A method according to claim 1, wherein the conductive material is a semiconductor material.

10. A method according to claim 1 or 9, wherein the conductive material is silicon.

11. A method according to claim 9, wherein the semiconductor material has a polycrystaline morphology.

## Patentansprüche

1. Ein Verfahren zur Herstellung eines integrierten Schaltkreises, der mindestens ein passives Bauelement (70) trägt, wobei das Verfahren die Bereitstellung eines Halbleitersubstrates (10), auf welchem ein passives Bauelement ausgebildet sein kann, die Ablagerung einer Schicht eines leitfähigen Materiales (30) auf besagtem Substrat (10), die Bereitstellung einer strukturierten Resistschicht (82) auf besagter Schicht aus leitfähigem Material (30) als eine Maske und das Ätzen von besagter Schicht von leitfähigem Material (30) umfasst, **dadurch gekennzeichnet, dass** das Verfahren des Weiteren die Durchführung eines Ionen-Implantationsschrittes (84) umfasst, um so eine amorphe Schicht (86) auf besagtem Substrat in den Bereichen zu schaffen, welche nicht durch besagte geätzte Schicht des leitfähigen Materials (30) und der besagten strukturieren Resistschicht (82) abgedeckt ist, und wobei nach besagtem Ionen-Implantationsschritt die besagte strukturierte Resistschicht (82) entfernt wird.

2. Ein Verfahren gemäß Anspruch 1, wobei der Ionen-Implantationsschritt unter Verwendung von schweren Ionen durchgeführt wird.

3. Ein Verfahrengemäß Anspruch 2, wobei besagte schwere Ionen Argon umfassen.

4. Ein Verfahren gemäß Anspruch 1, wobei besagtes passives Bauelement einen mehrteiligen Induktor (70) umfasst, welcher eine auf dem Substrat (10) ausgebildete Metallspirale umfasst.

5. Ein Verfahren gemäß Anspruch 1, wobei besagter integrierter Schaltkreis mindestens ein zusätzliches passives Bauelement trägt.

6. Ein Verfahren gemäß Anspruch 5, wobei besagtes mindestens ein zusätzliches passives Bauelement einen ebenen Kondensator (40), einen Grubenkondensator (50) oder einen Widerstand (60) umfasst.

7. Ein Verfahren gemäß Anspruch 1, wobei das mindestens eine passive Bauelement mittels einer dielektrischen Schicht von dem Halbleitersubstrat isoliert ist.

8. Ein Verfahren gemäß Anspruch 7, wobei besagte dielektrische Schicht Siliziumdioxid umfasst und das besagte Substrat ein Siliziumsubstrat umfasst.

9. Ein Verfahren gemäß Anspruch 1, wobei das leitfähige Material ein Halbleitermaterial ist.

10. Ein Verfahren gemäß Anspruch 1 oder 9, wobei das leitfähige Material Silizium ist.

11. Ein Verfahren gemäß Anspruch 9, wobei das Halbleitermaterial eine polykristalline Morphologie aufweist.

## Revendications

1. Procédé de fabrication d'un circuit intégré portant au moins un composant passif (70), ledit procédé comprenant la mise en place d'un substrat semi-conducteur (10) sur lequel on peut former un composant passif, le dépôt d'une couche de matériau conducteur (30) sur ledit substrat (10), la mise en place sur ladite couche de matériau conducteur (30) d'une couche de résine mise en forme (82) en tant que masque et la gravure de ladite couche de matériau conducteur (30), **caractérisé par le fait que** le procédé comporte en outre la réalisation d'une étape d'implantation ionique (84), afin de créer une couche amorphe (86) sur ledit substrat dans les zones de celui-ci qui n'ont pas été couvertes par ladite couche gravée de matériau semi-conducteur (30) et ladite couche de résine mise en forme (82), et après ladite étape d'implantation ionique, élimination de ladite couche de résine mise en forme (82).

2. Procédé selon la revendication 1, dans lequel l'étape d'implantation ionique est réalisée avec des ions lourds.

3. Procédé selon la revendication 2, dans lequel lesdits ions lourds comprennent de l'argon.

4. Procédé selon la revendication 1, dans lequel ledit composant passif comporte une inductance multi-tours (70), comprenant une spirale métallique formée sur le substrat (10).

5. Procédé selon la revendication 1, dans lequel ledit circuit intégré porte au moins un composant passif supplémentaire.

6. Procédé selon la revendication 5, dans lequel ledit composant passif additionnel au moins comporte un condensateur planaire (40), un condensateur en puits (50) ou une résistance (60).

7. Procédé selon la revendication 1, dans lequel ledit composant passif au moins est isolé du substrat semi-conducteur par une couche diélectrique.

8. Procédé selon la revendication 7, dans lequel ladite couche diélectrique comporte du dioxyde de silicium et dans lequel ledit substrat comporte un substrat de silicium.

9. Procédé selon la revendication 1, dans lequel le matériau conducteur est un matériau semi-conducteur.

10. Procédé selon les revendications 1 ou 9, dans lequel le matériau conducteur est du silicium.

11. Procédé selon la revendication 9, dans lequel le matériau semi-conducteur a une morphologie poly-cristalline.
